Europäisches Patentamt

European Patent Office

Office européen des brevets

(19)

(11) EP 0 735 378 A2

(12) EUROPÄISCHE PATENTANMELDUNG

(43) Veröffentlichungstag:
02.10.1996 Patentblatt 1996/40

(51) Int. Cl.$^6$: **G01R 31/265**, G01N 21/64

(21) Anmeldenummer: 96103947.6

(22) Anmeldetag: 13.03.1996

(84) Benannte Vertragsstaaten:
**DE FR GB IT NL**

(30) Priorität: 31.03.1995 DE 19511869

(71) Anmelder: **JENOPTIK Aktiengesellschaft**
**D-07743 Jena (DE)**

(72) Erfinder:
• **Geiler, Hans-Dieter**
**07745 Jena (DE)**
• **Wagner, Matthias**
**07745 Jena (DE)**

(54) **Verfahren und Anordnung zur Responseanalyse von optisch angeregten Halbleitermaterialien**

(57) Die Erfindung betrifft ein Verfahren und Anordnungen zur Responseanalyse von optisch angeregten Halbleitermaterialien.

Die Aufgabe der Erfindung, eine neue Art der Responseanalyse von Halbleitermaterialien mit optischer Anregung zu finden, die eine hinreichend genaue Detektion der Ladungsträgerwelle auch bei höherer Anregungsleistung und kleiner Ladungsträgerlebensdauer zuläßt, wird erfindungsgemäß gelöst, indem ein anregender Laserstrahl mit zwei diskreten Modulationsfrequenzen $(\Omega_1; \Omega_2)$ intensitätsmoduliert ist, das aus dem Objekt (4) austretende Lumineszenzlicht auf der Differenzfrequenz $(\Omega_1-\Omega_2)$ gemessen wird und das Lumineszenzlicht als Funktion des arithmetischen Mittels $(\Omega)$ der Modulationsfrequenzen $(\Omega_1; \Omega_2)$ analysiert wird.

Die Erfindung findet Anwendung in der Halbleiterindustrie zur Bestimmung verschiedener elektrischer Parameter von Halbleitermaterialien.

Fig. 1

EP 0 735 378 A2

**Beschreibung**

Die Erfindung betrifft ein Verfahren und eine Anordnung zur Responseanalyse von optisch angeregten Halbleitermaterialien, wobei in einem Objekt mittels eines Laserstrahls eine elektronische Energiedeponierung in Form angeregter Ladungsträger erzeugt und deren Relaxation in Form einer aus der Probe austretenden Lumineszenzstrahlung gemessen wird.

Die meßtechnische Aufgabenstellung, eine Analyse der Rekombinationskanäle in Festkörpern, vornehmlich in Halbleitern, mit hoher Ortsauflösung vorzunehmen, wird derzeit in der Praxis sowohl mit kontaktierenden als auch kontaktfreien Methoden bearbeitet.

Die elektrischen oder photoelektrischen Methoden, die jeweils eine einfache Modulation mit Lock-in-Detektion (im Falle der Frequenzdomäne) oder mit Box-car-Integration (im Falle der Zeitdomäne) verwenden, haben den grundsätzlichen Nachteil der notwendigen Kontaktierung. Bei den kontaktfreien Methoden ist die Messung der Photolumineszenz eines der ältesten Charakterisierungsverfahrens für die strahlende Rekombination (siehe z.B. W.D. Johnston in Appl. Phys. Lett. $\underline{33}$ (1978) 992). Eine modulierte Anregung sichert die notwendige Meßempfindlichkeit, und eine hohe Ortsauflösung ist durch die Wahl der Modulationsfrequenz möglich, wie man beispielsweise aus einem Artikel von J. Marek in: Appl. Phys. Lett. $\underline{49}$ (1986) 1732 entnehmen kann. Die ortsaufgelöste Photolumineszenz wird in der Regel mit geringen Anregungsdichten der Ladungsträgerwelle durch modulierte Laserstrahlung erzeugt. Eine Intensitätsauswertung ist dabei mit großen Fehlern behaftet, so daß regelmäßig nur eine Spektroskopie betrieben wird. Außerdem bleibt wegen der einfachen Abtrennung des Gleichlichtanteils die Modulation aufniedrige Frequenzen beschränkt.

Weiterhin sind im Stand der Technik als kontaktfreie Methoden unterschiedliche Verfahren der photothermischen Spektroskopie mit hohen Anregungsenergien bekannt, von denen stellvertretend als Quellen die US-PS 4,579,463, die DE 40 35 266 und DE 42 23 337 genannt sein sollen. Bei diesen Verfahren stellt sich als Problem die Dominanz der Thermowelle dar, so daß bei den gemessenen Parametern der Einfluß der thermischen Materialeigenschaften überwiegt und bei Ladungsträgerlebensdauern < 1 μs der Einfluß der Ladungsträgerwelle gegen Null geht. Damit verschlechtert sich die Aussagefähigkeit bezüglich elektrischer Eigenschaften extrem.

Der Erfindung liegt deshalb die Aufgabe zugrunde, eine neue Möglichkeit zur Responseanalyse von optisch angeregten Halbleitermaterialien zu finden, die eine hinreichend genaue Detektion der Ladungsträgerwelle auch bei höherer Anregungsleistung und kleiner Ladungsträgerlebensdauer zuläßt.

Eine erweiterte Aufgabe der Erfindung ist es, mittels optischer Anregung des Halbleiters strahlende und strahlungslose Kanäle der Ladungsträgerrekombination zu detektieren und einzeln auswertbar zu machen.

Erfindungsgemäß wird die Aufgabe bei einem Verfahren zur Responseanalyse von optisch angeregten Halbleitermaterialien, wobei in einem Objekt mittels eines Laserstrahls eine elektronische Energiedeponierung in Form angeregter Ladungsträger erzeugt wird, deren Relaxation in Form einer aus dem Objekt austretenden Lumineszenz-Strahlung gemessen wird, dadurch gelöst, daß der anregende Laserstrahl intensitätsmoduliert ist, wobei das Frequenzspektrum zwei diskrete Modulationsfrequenzen aufweist, daß das aus dem Objekt austretende Lumineszenzlicht auf einer Mischfrequenz, entweder der Summen- oder der Differenzfrequenz der Modulationsfrequenzen, gemessen wird, und daß das Lumineszenzlicht als Funktion des arithmetischen Mittels der Modulationsfrequenzen analysiert wird.

Vorteilhaft werden die zwei Modulationsfrequenzen im anregenden Laserstrahl durch die Zusammensetzung des Laserstrahls aus zwei Teilstrahlen erzeugt, wobei jeder Teilstrahl mit einer der Modulationsfrequenzen intensitätsmoduliert ist.

Um vom bloßen Lumineszenz-Mapping (der ortsaufgelösten Lumineszenzmessung) zu Meßwerten zu gelangen, aus denen über eine Modellberechnung die elektrischen Parameter des Halbleiters direkt bestimmbar sind, werden zweckmäßig die Modulationsfrequenzen des anregenden Laserstrahls in weiten Grenzen variiert (Frequenzsweep), wobei die Differenz der Modulationsfrequenzen konstant gehalten wird.

Vorteilhaft werden die zwei Teilstrahlen senkrecht zueinander polarisiert. Weiterhin ist es für die Messung von Ladungsträgerlebensdauern von Vorteil, daß die zwei Teilstrahlen auf räumlich getrennte, eng benachbarte Auftreffpunkte des Objektes fokussiert werden. Dabei ist es zweckmäßig, die Teilstrahlen in einem Abstand von höchstens der zweifachen zu erwartenden Diffusionslänge der angeregten Ladungsträger auf das Objekt zu fokussieren.

Eine weitere vorteilhafte Möglichkeit der Erzeugung der zwei diskreten Modulationsfrequenzen im anregenden Laserstrahl ergibt sich durch geeignete Amplitudenmodulation, indem der Laserstrahl mit einer Trägerfrequenz $f_1 = (\Omega_1 + \Omega_2)/2$ und einer Grundtaktfrequenz $f_2 = \Omega_1 - \Omega_2$ moduliert wird und eine Komponente der Grundtaktfrequenz, die zu einer aus der Trägerfrequenz und den Seitenbändern ($f_1 \pm f_2$) resultierenden Mischfrequenz phasengleich ist, erfaßt und mittels Rückkopplung dieser Komponente als Störgröße auf den Modulationsprozeß vernichtet wird. Auch bei dieser Variante der Doppelmodulation des anregenden Laserstrahls werden zweckmäßig die beiden Modulationsfrequenzen bei konstant gehaltener Differenz in weiten Grenzen variiert (Frequenzsweep), um elektrische Parameter des Objekts bestimmen zu können.

Zur Erfassung der Lumineszenzstrahlung sind generell drei Varianten (unabhängig von der Art der Anregung) sinnvoll. Eine regelmäßig vorteilhafte Variante, insbesondere für Halbleiterobjekte großer Dicke, stellt die Erfassung der Lumineszenz auf der Anregungsseite des Objekts dar. Zweckmäßig, vor allem wegen der automatisch guten Abschirmung des anregenden Laserstrahls, wird die Lumineszenz auf der bezüglich der Anregung determinierten Objektrückseite aufgenommen. Durchaus vorteilhaft läßt sich die Messung der Photolumineszenz auch auf einer beliebig lateral bezüglich der Anregungsseite des Objekts befindlichen Seitenfläche, z.B. an der Umfangsfläche eines Halbleiterwafers, messen.

Zur Lösung der erweiterten Aufgabe wird in vorteilhafter Weise zusätzlich zur Messung des Lumineszenzlichts eine photothermische Response aus dem Laserstrahl nach seiner Wechselwirkung mit dem Objekt aufgenommen und eine Analyse und Korrelation durchgeführt, so daß die nichtstrahlende Response des Objekts aus der photothermischen und der Lumineszenzresponse separiert werden kann. Die Detektion der photothermischen Response geschieht dabei in bekannter Weise, wie z. B. in DE 40 35 266 und DE 42 23 337 beschrieben.

Vorteilhaft bei der kombinierten, gleichzeitigen Erfassung von Photolumineszenz und photothermischer Response ist die räumliche Trennung der Aufnahme der Meßsignale, indem die beiden Meßwerterfassungen auf unterschiedlichen Seiten des Objekts stattfinden. Zweckmäßig ist wegen der häufig geringen Lasertransparenz des Objekts eine Erfassung der photothermischen Response auf der Anregungsseite und die Aufnahme der Lumineszenz an einer anderen Seite des Objekts (z.B. Rückseite oder Seitenfläche).

Die Aufgabe der Erfindung wird bei einer Anordnung zur Responseanalyse von optisch angeregten Halbleitermaterialien, bei der ein Laserstrahl zur Erzeugung einer elektronischen Energiedeponierung in Form angeregter Ladungsträger auf ein Objekt fokussiert ist und ein Lumineszenzdetektor zur Messung einer aus dem Objekt austretenden Lumineszenz-Strahlung vorgesehen ist, erfindungsgemäß dadurch gelöst, daß der Laserstrahl intensitätsmoduliert ist und in seinem Modulationsspektrum zwei diskrete Modulationsfrequenzen enthält, daß der Lumineszenzdetektor mit einer frequenzselektiven Einrichtung verknüpft ist, wobei aus der Lumineszenzstrahlung nur Anteile auf einer Mischfrequenz, der Summen-oder der Differenzfrequenz der Modulationsfrequenzen, detektierbar sind, die aus einer im Objekt stattfindenden Frequenzumsetzung resultieren, und daß dem Lumineszenzdetektor eine Signalverarbeitungseinrichtung nachgeordnet ist, die die frequenzselektiv erfaßten Detektorsignale als Funktion des arithmetischen Mittels der Modulationsfrequenzen analysiert.

Vorteilhaft wird zur Erzeugung des doppelt modulierten Laserstrahls eine Laserquelle eingesetzt, wobei eine Modulatorbaugruppe zur Modulation der Laserquelle mit beiden Modulationsfrequenzen vorhanden ist. Eine weitere zweckmäßige Variante zur Erzeugung des doppelt modulierten Laserstrahls beinhaltet, daß der Laserstrahl aus zwei Teilstrahlen zusammengesetzt wird, wobei jeder Teilstrahl mit einer der Modulationsfrequenzen moduliert ist und die Modulation von einer Modulatorbaugruppe gesteuert wird.

Die zwei Teilstrahlen lassen sich zum einen vorteilhaft aus einer Laserquelle mit einem optischen Teiler erzeugen, wobei in jedem Teilstrahl ein optischer Modulator zur Modulation mit jeweils einer der Modulationsfrequenzen angeordnet ist und den Modulatoren optische Mittel zur Vereinigung der Teilstrahlen nachgeordnet sind. Zweckmäßig sind in den Teilstrahlen optische Mittel zur Polarisation vorhanden, so daß die Teilstrahlen zueinander orthogonale Polarisation aufweisen.

Zum anderen ist es für die Erzeugung der Teilstrahlen günstig, daß zwei separate Laserquellen vorhanden sind, wobei jede Laserquelle mit einer der Modulationsfrequenzen angesteuert wird. Dabei erweist es sich als vorteilhaft, zwei Laserdioden einzusetzen, wobei deren polarisiertes Licht senkrecht zueinander polarisierte Teilstrahlen bildet. Die so erzeugten Teilstrahlen werden im einfachsten Fall parallel zueinander in eine gemeinsame Optik geführt und auf einen Punkt der Objektoberfläche fokussiert. Zweckmäßig werden die Teilstrahlen koinzident zusammen geführt.

In einer speziellen Anordnung erweist es sich von Vorteil, daß die Teilstrahlen nicht parallel in die gemeinsame Optik geführt sind, so daß eng benachbarte, räumlich getrennte Anregungszentren der Teilstahlen auf dem Objekt entstehen. Damit sind Aussagen über Diffusionslänge und Beweglichkeit der angeregten Ladungsträger erzielbar. Bei der Bereitstellung des doppelt modulierten Laserstrahls ist es für die Berechnung der elektrischen Materialparameter des Objekts vorteilhaft, wenn der Modulatorbaugruppe eine Ansteuereinrichtung zugeordnet ist, die eine Verschiebung der Modulationsfrequenzen in weiten Grenzen (Frequenzsweep) realisiert, wobei die Differenz der Modulationsfrequenzen stets konstant bleibt. Aus der Frequenzabhängigkeit der Intensitätsmessung der Lumineszenz kann der Charakter der strahlenden Relaxationsprozesse im Halbleiter bestimmt werden.

Für eine weitere Ausbildung der erfindungsgemäßen Anordnung ist es zweckmäßig, daß zusätzlich zum Lumineszenzdetektor ein Laserdetektor zur Erfassung des Laserstrahls nach seiner Wechselwirkung mit dem Objekt vorhanden ist. Diese gemäß den aus DE 40 35 266 und DE 42 23 337 bekannten Grundsätzen der Detektion der Thermowellenresponse ergänzte Anordnung gestattet es, den lumineszierenden Signalanteil der angeregten Ladungsträger von dem (vom Laserdetektor gelieferten) Gesamtsignal zu trennen. Diese Separierung basiert darauf, die photothermische Response und die lumineszierende Response miteinander korreliert über einen weiten Modulationsfrequenzbereich der optischen Objektanregung zu messen. Das Ergebnis sind Aussagen zum Anteil strahlender und strahlungsloser Kanäle im Halbleiter.

Zur Verhinderung einer Verfälschung des Lumineszenzsignals im Lumineszenzdetektor durch die anregende Laserstrahlung sind zwei Maßnahmen zweckmäßig, die für die Lumineszenzmessung in Reflexion bzw. für die Messung in Transmission besonders geeignet sind. Das Laserlicht wird einerseits mittels eines dichroitischen Spiegels und andererseits mit einem Absorptionsfilter abgetrennt. Beide sind auch kombiniert anwendbar oder können entfallen, wenn das Objekt die Laserstrahlung ausreichend abschirmt.

Die Grundidee der Erfindung basiert auf den Kenntnissen der Lumineszenz als strahlender Relaxationsmechanismus von Ladungsträgern in Halbleitern.

Sie gelten sinngemäß auch für alle anderen in einem Material möglichen strahlenden Relaxationsprozesse.

Für die Messung der Lumineszenz sind verschiedene Verfahren periodisch und nichtperiodisch modulierter, optischer Materialanregung bekannt, wie z.B. aus der EP 0545523. Eine Anregung mit mehreren, im einfachsten Fall zwei Frequenzen $\Omega_1$ und $\Omega_2$ bietet dagegen den meßtechnischen Vorteil, unter Ausnutzung des inhärent nichtlinearen Charakters von Anregungs- und Relaxationsprozeß eine Frequenzumsetzung aus dem Anregungsfrequenzbereich in eine meßtechnisch günstige Meßfrequenz zu erreichen. Im einfachsten Fall einer quadratischen Abhängigkeit der Lumineszenzintensität von der Anregungsintensität finden sich in der das Meßobjekt verlassenden Lumineszenzstrahlung neben den Originalfrequenzen der Anregung $\Omega_1$ und $\Omega_2$ deren Summen- und Differenzfrequenzen $\Omega_1 \pm \Omega_2$. Damit wird es in einfacher Weise möglich, durch Detektion der Anteile bei der konstanten Differenzfrequenz $\Omega_1$-$\Omega_2$ eine Analyse der Relaxation in einem breiten Frequenzbereich der Anregung auszuführen und dabei auch in den Bereich hoher und höchster Frequenzen vorzudringen, der meßtechnisch mit den bekannten Methoden nur schwer und unter Genauigkeitsverlust zugänglich ist. Aus der Frequenzabhängigkeit der Intensität des gemessenen Lumineszenzlichtes kann der Charakter der strahlenden Relaxationsprozesse, d.h. vor allem deren zeitliches Verhalten, bestimmt werden.

Eine erste Erweiterung des Grundgedankens der Erfindung gestattet die Gewinnung von Aussagen über Diffusionslänge und Beweglichkeit der angeregten Ladungsträger im Objekt: Zur Anregung wird eine Kombination aus zwei Teilstrahlen verwendet, von denen jeder mit je einer der beiden Frequenzen $\Omega_1$ und $\Omega_2$ intensitätsmoduliert ist und die durch optische Mittel derart geführt werden, daß sie an räumlich getrennten Stellen auf das Objekt auftreffen. Die an den Anregungszentren erzeugte Ladungsträgerkonzentration wird entsprechend dem auftreffenden Teilstrahl entweder mit der Frequenz $\Omega_1$ oder mit der Frequenz $\Omega_2$ moduliert. Lumineszenzlicht, das mit der Differenzfrequenz $\Omega_1$-$\Omega_2$ moduliert ist, entsteht in diesem Fall nur in dem Raumbereich, in dem sich die mit $\Omega_1$ bzw. $\Omega_2$ modulierten Konzentrationen der Ladungsträger überlagern. Eine hinreichend starke Überlagerung ist gegeben, wenn der gegenseitige Abstand der Anregungsorte höchstens zwei Diffusionslängen der angeregten Ladungsträger beträgt. Die Variation des Abstandes der beiden Auftreffpunkte der anregenden Laserstrahlen gestattet es deshalb, in einfacher Weise die Dimension dieses Raumbereiches zu bestimmen, indem die Abhängigkeit der Intensität des Lumineszenzlichtes bei der Differenzfrequenz $\Omega_1$-$\Omega_2$ vom Abstand der Teilstrahlen und deren mittlerer Modulationsfrequenz $(\Omega_1+\Omega_2)/2$ analysiert wird.

Eine zweite Erweiterung des Erfindungsgedankens betrifft die Kombination der Analyse der strahlenden Relaxation (Photolumineszenz) mit der Analyse des photothermischen Responsesignals.

Es ist als allgemeines Problem photothermischer Messungen insbesondere an Halbleitern bekannt, daß angeregte Ladungsträger einen merklichen Beitrag zur Gesamtresponse des Objektes liefern. Durch die separate Messung der durch die Ladungsträger-Rekombination generierten Strahlung wird es möglich, den Signalanteil der strahlenden Relaxation angeregter Ladungsträger vom Gesamtsignal zu trennen. Die Separierung basiert darauf, die photothermische Response und das Lumineszenzsignal des Objektes miteinander korreliert über einen weiten Bereich von Modulationsfrequenzen der optischen Anregung zu messen. In diesem Meßprozeß wird die photothermische Response-Analyse ebenfalls auf der Basis der Frequenzumsetzung betrieben (Photothermisches Heterodyn), wie in Meas. Sci. Technol. 2 (1991) 1088-1093 beschrieben.

In dem das Objekt verlassenden Teil des Anregungsstrahles sind frequenzkonvertierte Anteile enthalten, die vom Zusammenwirken strahlungsloser und strahlender Relaxationsprozesse geprägt sind, während die Frequenzkonversion im Lumineszenzlicht des Objektes allein aus den strahlenden Prozessen herrührt. Damit ist es möglich, den Responseanteil der strahlenden Prozesse durch eine korrelierte Messung beider Responsetypen abzutrennen und Aussagen über den nichtstrahlenden Anteil zu gewinnen.

Mit der Anwendung des erfindungsgemäßen Verfahrens in seiner Grundvariante wird erreicht, von strahlenden Relaxationsprozessen bei Hochfrequenzanregung und kleiner Ladungsträgerlebensdauer (< 1 μs) mit einfachen Mitteln örtlich und bezüglich des Signal-Rausch-Verhaltens hochaufgelöste Lumineszenzmessungen aus dem Bereich des Band-Band-Übergangs zu erhalten. Diese Messungen sind auch bei hohen Temperaturen der Meßobjekte (z.B. Halbleitersubstrate) zuverlässig möglich. Erweiterte Verfahrensvarianten und entsprechende spezielle erfindungsgemäße Anordnungen gestatten eine Frequenzanalyse der Ladungsträgerwelle, die Gewinnung von Aussagen über Diffusionslänge und Beweglichkeit von angeregten Ladungsträgern sowie eine Separierung von Signalanteilen strahlender und strahlungsloser Response des Objekts, um Aussagen über lumineszierende und strahlungslose Kanäle in Halbleitern und verschiedene elektrische Materialparameter treffen zu können.

Die Erfindung soll nachstehend anhand von Ausführungsbeispielen näher erläutert werden. Die Zeichnungen zeigen:

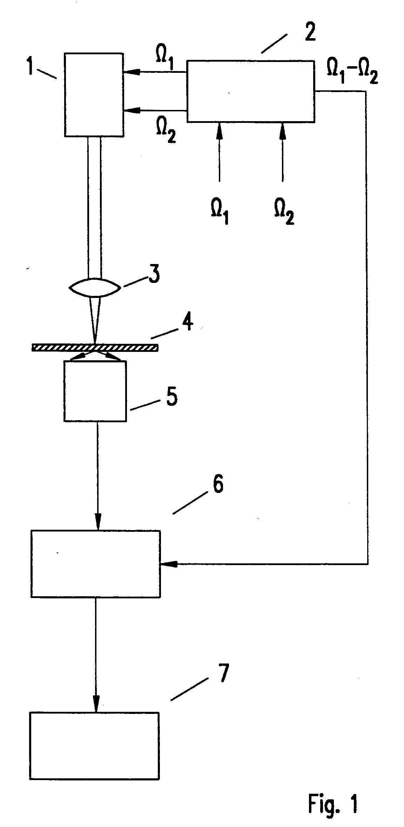

Fig. 1    den erfindungsgemäßen Grundaufbau in einer Variante, bei der das Lumineszenzlicht auf der der Anregung abgewandten Objektrückseite detektiert wird,

EP 0 735 378 A2

| | |
|---|---|
| Fig.2 | den erfindungsgemäßen Grundaufbau in einer Variante, bei der das Lumineszenzlicht auf der Anregungsseite des Objektes detektiert wird, |
| Fig.3 | eine erfindungsgemäße Anordnung zur kombinierten Lumineszenz- und photothermischen Spektroskopie mit Frequenzumsetzung, bei der der anregende Laserstrahl aus zwei senkrecht zueinander polarisierten Teilstrahlen zusammengesetzt ist, |
| Fig.4 | eine weitere erfindungsgemäße Anordnung zur kombinierten Lumineszenz-und photothermischen Spektroskopie mit Frequenzumsetzung, bei der das Lumineszenzlicht auf der Anregungseite des Objektes detektiert wird, |
| Fig.5 | eine erfindungsgemäße Anordnung zur kombinierten Lumineszenz- und photothermischen Spektroskopie, bei der die Anregung mit einem Laserstrahl mit getakteter Modulation erfolgt, |
| Fig.6 | den zeitlichen Verlauf der Intensitätsmodulation für die in Fig.5 beschriebene Ausführungsvariante, |
| Fig.7 | eine erfindungsgemäße Anordnung mit zwei Teilstrahlen, die in räumlich voneinander getrennten Anregungszentren das Objekt anregen, |
| Fig.8 | eine weitere erfindungsgemäße Anordnung mit zwei räumlich voneinander getrennt anregenden Teilstrahlen, |
| Fig.9 | eine erfindungsgemäße Anordnung mit lateraler Detektion des Lumineszenzlichtes, |
| Fig.10 | die Lumineszenz-Formfunktion $F_{cL}$ in Abhängigkeit vom Produkt aus der mittleren Modulationsfrequenz $\Omega$ und mittlerer Lebensdauer $\tau$ der Überschußladungsträger, |
| Fig.11 | die Lumineszenz-Formfunktion wie in Fig. 10 mit geändertem, normierten Parameter |

Das erfindungsgemäße Verfahren umfaßt in seiner Grundvariante

- einen Energieeintrag in das Objekt mittels intensitätsmodulierter Laserstrahlung mit zwei diskreten Modulationsfrequenzen $\Omega_1$ und $\Omega_2$
- die Detektion des aus dem Objekt 4 austretenden Lumineszenzlichtes auf der Summen- $(\Omega_1+\Omega_2)$ oder der Differenzfrequenz $(\Omega_1-\Omega_2)$ sowie
- die Analyse des erfaßten Lumineszenzlichts als Funktion des arithmetischen Mittels der Modulationsfrequenzen

Realisiert wird das Verfahren mit einer Anordnung gemäß Fig. 1. Ein Laserstrahl wird von einer Laserquelle 1 erzeugt, die mittels einer Modulatorbaugruppe 2 in ihrer Intensität mit den beiden Modulationsfrequenzen $\Omega_1$ und $\Omega_2$ moduliert wird. Die Modulationsfrequenzen $\Omega_1$ und $\Omega_2$ sind zweckmäßig beliebig im Frequenzbereich von 100 kHz bis 2 MHz eingebbar und sind in der Regel relativ eng benachbart gewählt (z.B. $(\Omega_1-\Omega_2) \approx 10$ kHz). Diesen Sachverhalt verdeutlichen die Eingabepfeile mit $\Omega_1$ und $\Omega_2$ an der Modulatorbaugruppe 2. Der Laserstrahl wird mittels einer Optik 3 fokussiert und auf das Objekt 4 geführt. Das aus der Rückseite des Objektes 4 austretende Lumineszenzlicht wird von einem Lumineszenzdetektor 5 erfaßt. Da das Lumineszenzlicht nicht kollimiert austritt, soll dieser Detektor einen möglichst großen Raumwinkel erfassen, um Signalverluste zu minimieren. Er wird deshalb möglichst dicht der Rückseite des Objektes 4 genähert. Vom Lumineszenzdetektor 5 gelangt das Meßsignal zu einem Lock-In-Verstärker 6, der auf die Differenzfrequenz $(\Omega_1-\Omega_2)$ abgestimmt ist und sein Referenzsignal aus der Modulatorbaugruppe 2 bezieht. Die weitere Signalverarbeitung erfolgt mit einem Signalprozessor 7, der das Ausgangssignal des Lock-In-Verstärkers 6 erfaßt und dieses Signal in Abhängigkeit von $\Omega_1$ und $\Omega_2$ aufzeichnet und bewertet.

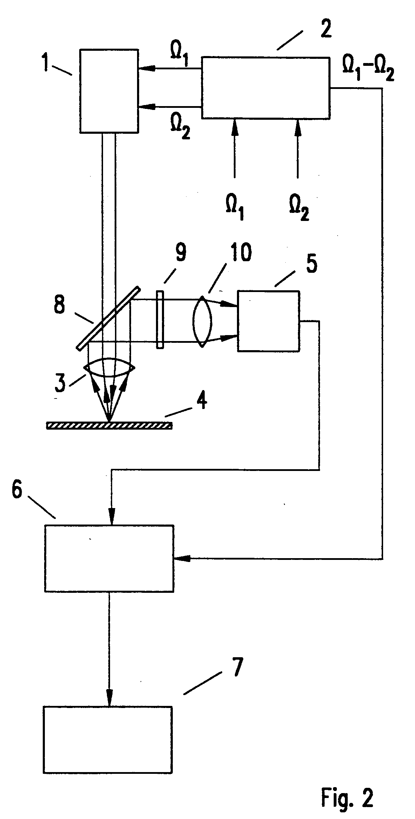

In der Anordnung gemäß Fig.2 wird der Laserstrahl von der Laserdiode 1 erzeugt, die mittels der Modulatorbaugruppe 2 in ihrer Intensität mit den beiden Modulationsfrequenzen $\Omega_1$ und $\Omega_2$ moduliert wird. Der Laserstrahl wird durch einen dichroitischen Spiegel 8 und die Optik 3 auf das Objekt 4 geführt. Der dichroitische Spiegel 8 ist für die Wellenlänge des Laserlichtes transparent und besitzt für das Lumineszenzlicht einen vergleichsweise hohen Reflexionsfaktor. Das an der Vorderseite des Objektes 4 austretende Lumineszenzlicht wird von der Optik 3 kollimiert, am dichroitischen Spiegel 8 reflektiert und von einer Optik 10 auf den Lumineszenzdetektor 5 geführt. Falls der dichroitische Spiegel 8 für die Abtrennung des Laserlichtes nicht genügend wirksam ist, wird ein Absorptionsfilter 9 in den Strahlengang eingefügt. Vom Lumineszenzdetektor 5 gelangt das Meßsignal wiederum zum Lock-In-Verstärker 6. Die weitere Signalverarbeitung entspricht der Beschreibung in Fig. 1.

Eine Erweiterung des erfindungsgemäßen Verfahrens wird durch die Ausführung eines Frequenzsweeps erreicht, der sich problemlos realisieren läßt, ohne daß Änderungen bei der Detektion notwendig sind. Die Modulationsfrequenzen $\Omega_1$ und $\Omega_2$ werden über einen weiten Frequenzbereich variiert, wobei lediglich dafür gesorgt werden muß, daß die Frequenzdifferenz $(\Omega_1 - \Omega_2)$ konstant bleibt. Damit erweitern sich die Möglichkeiten der Meßwertauswertung erheblich, wie weiter unten anhand der theoretischen Überlegungen dargelegt wird.

Eine weitere Ausgestaltung der Erfindung besteht in der Kombination der Lumineszenzlichterfassung und der Aufnahme der photothermischen Response aus dem Laserstrahl nach dessen Wechselwirkung mit dem Objekt 4. Beide Responseprozesse werden zeitgleich aufgenommen, so daß sie jeweils demselben Ort des Objektes 4 zugeordnet sind. Der Auswertemodus wird im folgenden erläutert.

Die erfindungsgemäße Detektion der Lumineszenz-Response bei der Differenz-bzw. Grundtaktfrequenz erlaubt die Frequenzanalyse der Ladungsträgerwelle durch Variation der Anregungfrequenz in einem möglichst großen, auf alle Fälle aber in einem den Kehrwert der Ladungsträgerlebensdauern $\tau$ überstreichenden Intervall. Das Signal S, welches eine empfangene Lumineszenz-Lichtleistung darstellt, ist dann durch räumliche Aufintegration aller vom Detektor erfaßten Lumineszenzanteile zu gewinnen (erfaßt wird idealerweise die Strahlung in einen Halbraum HR hinein):

$$S = LE_g\beta \int_{HR} d^3\vec{r}\, \{n\cos(\Omega_1 t+\Psi_n)p\cos(\Omega_2 t+\Psi_p)+n\cos(\Omega_2 t+\Psi_n)p\cos(\Omega_1 t+\Psi_p)\} \qquad (1)$$

Die jeweilige Elektronenwelle $n(\vec{r}\,;t)$ bzw. Lochwelle $p(\vec{r}\,;t)$ ist dabei in Amplitude n bzw. p (Konzentration der Überschußladungsträger im Band) und Phase $\Psi_n$ bzw. $\Psi_p$ vom Ort $\bar{r}$ abhängig. Die Signalleistung ergibt sich gemäß (1) aus dem Lumineszenzlichtschwächungsfaktor L, der mittleren Energie des Lumineszenzlichtes $E_g$ und der Rekombinationsrate $\beta = \sigma_L v$ im Lumineszenzkanal. Letztere ist durch den Einfangquerschnitt für strahlende Rekombination $\sigma_L$ und die thermische Geschwindigkeit v der Ladungsträger im Band gegeben und besitzt die Dimension $[m^3 s^{-1}]$.
Einige wenige Umformungen der Winkelfunktionen in Gleichung (1) erlauben folgende Darstellung der Signalanteile S, die nur durch die Differenzfrequenz $\Omega_{12} = \Omega_1 - \Omega_2$ bestimmt sind:

$$S = LE_g\beta\cos(\Omega_{12}t) \cdot \int_{HR} d^3\vec{r}\, \{np\cos(\Psi_n-\Psi_p)\} \qquad (2)$$

$$= LE_g\beta\cos(\Omega_{12}t) \cdot \int_{HR} d^3\vec{r}\, \frac{1}{2}\{\hat{n}\cdot\hat{p}^*+\hat{n}^*\hat{p}\}$$

Der Ausdruck für den Betrag einer Ladungsträgerwelle (n,p) und der Phase ($\Psi_n,\Psi_p$) wurde durch die komplexen Größen $\hat{c} = ce^{i\Psi}$ ersetzt. (Die komplexe Konjugation ist durch * gekennzeichnet).
Man erkennt, daß die Phaseninformation über die Responsewelle nicht separierbar ist und für Überschußladungstäger ($\Psi_n \approx \Psi_p$) ganz verschwindet. Wohl aber bleibt die Extraktion der elektrischen Materialparameter ambipolare Diffusivität D, Oberflächenrekombinationsgeschwindigkeit s und Überschußladungsträger-Lebensdauer $\tau$ aus $\hat{n}$ $\hat{p}$ möglich. Für den idealisierten Fall der Ladungsträgerwellen (Kugelwellen) ist das Integral einfach berechenbar. Setzt man eine in einem durch den Laserspotradius w determinierten Absorptionsgebiet deponierte, modulierte Laserleistung P an, so bestimmt sich das Signal gemäß:

$$S = L \cdot \frac{P^2 w}{(\hbar\omega D)^2} \frac{\beta\cdot E_g}{\left|1+\dfrac{ws}{D}+p\right|^2} \frac{1}{\{p+p^*\}}; \quad p^2 = (1+i\Omega\tau)\frac{w^2}{D\tau} \qquad (3)$$

Dieses scaliert, wie ersichtlich, mit dem Laserspotradius w als Längenmaßstab für die Absolutmessung. Man beachte, daß in Gleichung (3) die dort definierte Größe p, wie allgemein üblich, die komplexe Wellenzahl der Ladungsträgerwelle bedeutet und deshalb nicht mit der Konzentration der Überschußlöcher $p(\vec{r}, t)$ zu verwechseln ist. Als Konversionseffizienz $K_L$ der Lumineszenzausbeute bei der Differenzfrequenz wird nun folgende Ergebnisgröße mit der Dimension $[W^{-1} m^{-1}]$ eingeführt:

$$K_L = \frac{S}{P^2 w} = L \cdot \frac{\beta\cdot E_g}{(\hbar\omega D)^2} \cdot F_{cL} \qquad (4)$$

Die dimensionslose Lumineszenz-Formfunktion $F_{cL}(\Omega)$ ist durch die mittlere Modulationsfrequenz $\Omega = (\Omega_1 + \Omega_2)/2$ über den Frequenzsweep bestimmt. Die Überschußladungsträgerlebensdauer $\tau$ setzt sich gemäß

$$\frac{1}{\tau} = \frac{1}{\tau_L} + \frac{1}{\tau_s} \qquad (5)$$

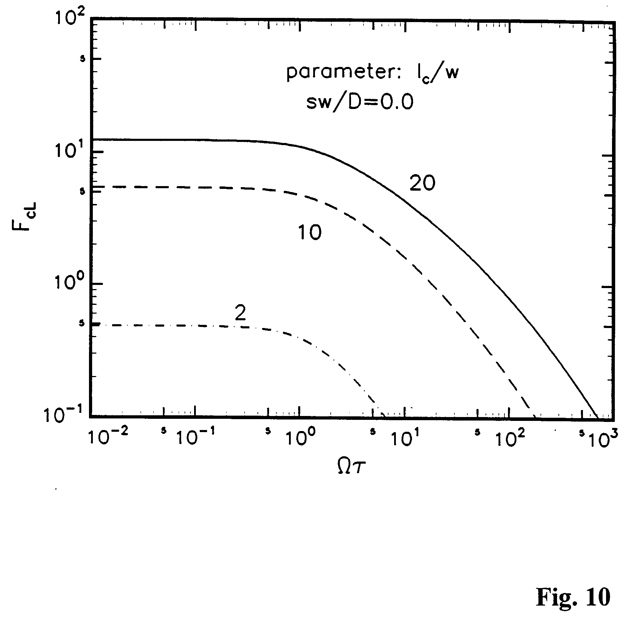

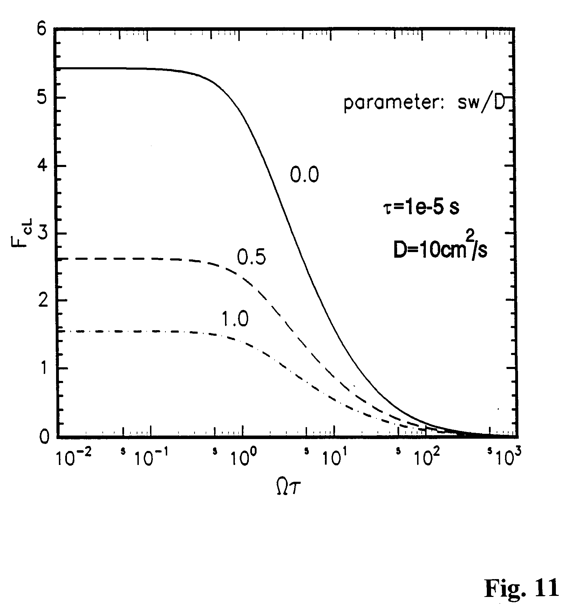

aus lumineszierenden ($\tau_L$) und strahlungslosen ($\tau_s$) Kanälen zusammen. Die Formfunktion ist für verschiedene Abhängigkeiten in den Fig. 10 und 11 dargestellt.

Fig. 10 zeigt die Lumineszenz-Formfunktion $F_{cL}$ über dem Produkt aus mittlerer Modulationsfrequenz und mittlerer Lebensdauer der Überschußladungsträger. Der Kurvenparameter ist die auf den Laserspotradius w normierte Ladungsträger-Diffusionslänge $l_c = \sqrt{(2D\,\tau)}$ bei einer Oberflächenrekombinationsgeschwindigkeit s = 0.

In Fig. 11 ist die Lumineszenz-Formfunktion $F_{cL}$ über dem Produkt aus mittlerer Modulationsfrequenz und der mittleren Lebensdauer der Überschüßladungsträger dargestellt.

Der Kurvenparameter ist die aufden Laserspotradius w und die Diffuvisität D normierte Oberflächenrekombinationsgeschwindigkeit s bei fester Diffusionslänge $l_c$.

Gerätetechnisch ergeben sich für die kombinierte Auswertung der lumineszierenden und der photothermischen Response mehrere Varianten.

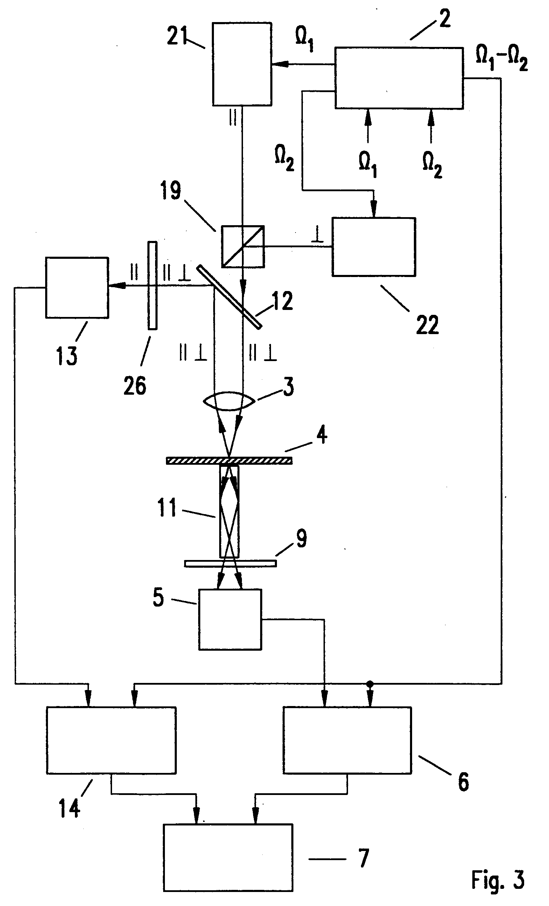

In der Anordnung gemäß Fig.3 wird der anregende Laserstrahl aus zwei senkrecht zueinander polarisierten Teilstrahlen zusammengesetzt, die von einer Laserdiode 21 und einer weiteren Laseriode 22 erzeugt werden. Die Laserdiode 21 wird von der Modulatorbaugruppe 2 in ihrer Intensität mit der Frequenz $\Omega_1$, die Laserdiode 22 mit $\Omega_2$ moduliert. Beide Teilstrahlen werden über eine Polarisationsweiche 19 zusammengefügt, passieren eine Teilerplatte 12 und werden mittels der Optik 3 auf das Objekt 4 fokussiert. Zusätzlich zu dem aus dem Objekt 4 austretenden Lumineszenzlicht soll in dieser Anordnung der Laserstrahl nach seiner Wechselwirkung mit dem Objekt 4 detektiert werden. Das aus dem Objekt 4 wieder austretende Laserlicht wird durch die Optik 3 kollimiert und trifft nach Reflexion an der Teilerplatte 12 auf einen dafür geeigneten Laserdetektor 13. Vor diesem Laserdetektor 13 ist ein Polarisationsfilter 26 angeordnet, das so orientiert ist, daß nur einer der beiden vom Objekt 4 zurücklaufenden Anregungsteilstrahlen vom Laserdetektor 13 erfaßt wird. Der polarisationsoptisch gefilterte Anteil des Laserlichts enthält die vollständige Information der photothermischen Response durch Frequenzumsetzung. Diese Tatsache eröffnet bei anderer Wahl des Polarisationsfilters 26 (z.B. in Form einer Polarisationsweiche) die Möglichkeit, den zweiten Laserlichtanteil für andere Zwecke (z.B. Referenzdetektor, Autofokusdetektor etc.) zu nutzen, ohne daß die Responsesignale auf dem Laserdetektor 13 verfälscht werden.

Das aus der Rückseite des Objektes 4 austretende Lumineszenzlicht wird - insbesondere wenn Platzmangel eine unmittelbare Positionierung des Lumineszenzdetektors 5 an der Objektoberfläche verhindert - verteilhaft mittels eines Lichtleiters 11 gesammelt und dem Lumineszenzdetektor 5 zugeführt. In dieser Ausführungsform wurde beispielhaft der Einsatz eines Lichtleiters 11 dargestellt, weil sich der Lumineszenzdetektor 5 (abhängig von seiner Bauform) nicht immer genügend weit der Rückseite des Objektes 4 nähern läßt. Als Lichtleiter 11 kann z.B. ein allseits polierter Glasstab oder ein Glasfaserbündel mit ausreichendem Eingangsquerschnitt eingesetzt werden. An Stelle des Lichtleiters 11 kann auch eine Kollimatoroptik mit genügend hoher Eintrittsapertur zur Erfassung des stark divergierenden Lumineszenzlichtes Anwendung finden. Falls das Objekt 4 für die Wellenlänge des anregenden Laserstrahles eine merkliche bzw. störende Transparenz aufweist, wird zusätzlich das Absorptionsfilter 9 in den Strahlengang eingefügt, das für das Lumineszenzlicht durchlässig ist und die Laserstrahlung absorbiert. Vom Lumineszenzdetektor 5 und vom Laserdetektor 13 gelangen die Meßsignale zum bereits beschriebenen Lock-In-Verstärker 6 bzw. zu einem weiteren Lock-In-Verstärker 14, der das vom Laserdetektor 13 gelieferte Signal in Amplitude und Phase analysiert. Beide Lock-In-Verstärker 6 und 14 sind auf die Differenzfrequenz ($\Omega_1$-$\Omega_2$) abgestimmt und beziehen ihr Referenzsignal aus der Modulatorbaugruppe 2. Ihre Ausgangssignale werden dem Signalprozessor 7 zugeführt, der über die bereits genannte Aufzeichnung und Bewertung der Meßsignale über die Anregungsfrequenz auch eine Korrelation der von den Lock-In-Verstärkern 6 und 14 ausgegebenen Meßsignale herstellt. Durch Anwendung von Algorithmen einer geeigneten oben erläuterten theoretischen Modellierung liefert der Prozessor getrennte Informationen für strahlende und nichtstrahlende Relaxationsmechanismen im Objekt. Ein Signalprozessor für eine solche umfangreiche Signalanalyse kann z.B. ein Mikrorechnersystem sein.

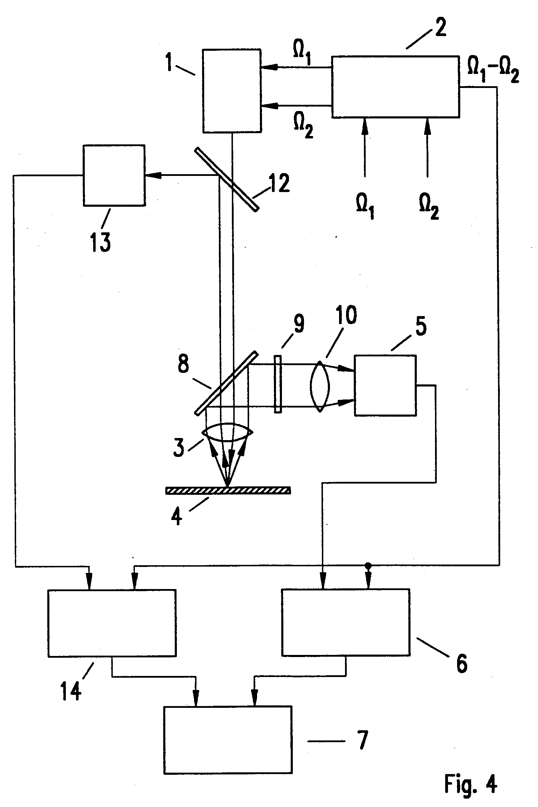

In der Anordnung gemäß Fig.4 wird der Laserstrahl von der Laserdiode 1 erzeugt, die mittels der Modulatorbaugruppe 2 in ihrer Intensität mit den beiden Modulationsfrequenzen $\Omega_1$ und $\Omega_2$ moduliert wird. Der Laserstrahl passiert eine Teilerplatte 12 und den dichroitischen Spiegel 8 und wird mittels der Optik 3 auf das Objekt 4 geführt. Das aus dem Objekt 4 wieder austretende Laserlicht wird durch die Optik 3 erfaßt und kollimiert, durchläuft den dichroitischen Spiegel 8 und trifft nach Reflexion an der Teilerplatte 12 auf einen dafür geeigneten Laserdetektor 13. Das an der Vorderseite des Objektes 4 austretende Lumineszenzlicht wird von der Optik 3 kollimiert, am dichroitischen Spiegel 8 reflektiert und von der Optik 10 auf den Lumineszenzdetektor 5 geführt. Falls der dichroitische Spiegel 8 für die Abtrennung des Laserlichtes nicht genügend wirksam ist, wird ein Absorptionsfilter 9 in den Strahlengang eingefügt. Vom Lumineszenzdetektor 5 gelangt das Meßsignal zum Lock-In-Verstärker 6, vom Laserdetektor 13 zum Lock-In-Verstärker 14. Die weitere Signalverarbeitung entspricht der Beschreibung zu Fig.3.

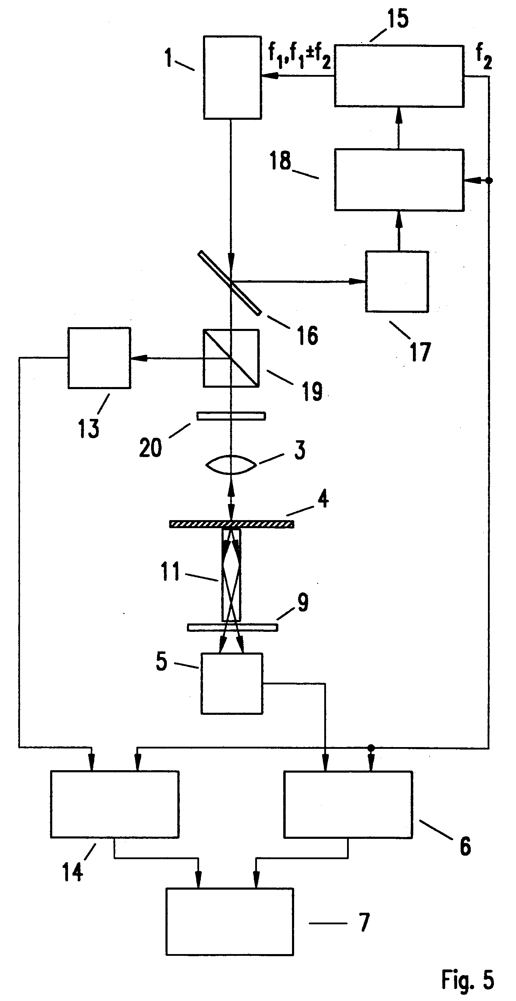

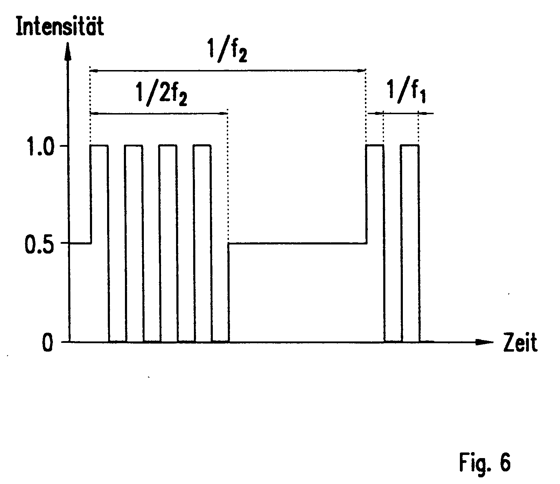

In der Anordnung gemäß Fig.5 wird der anregende Laserstrahl von der Laserdiode 1 erzeugt, die in ihrer Intensität durch eine Modulatorbaugruppe 15 moduliert wird. Der von dieser Modulatorbaugruppe 15 erzeugte Intensitätsverlauf des Laserstrahles über der Zeit ist in Fig.6 dargestellt. Über einen Strahlteiler 16 wird aus dem Laserstrahl ein Anteil ausgekoppelt und auf einen optischen Referenzdetektor 17 geleitet. Dieser Referenzdetektor 17 bildet zusammen mit einem Lock-In-Verstärker 18 und der Modulatorbaugruppe 15 eine Regelschleife. Diese Regelschleife bewirkt, daß der mit dem Referenzdetektor 17 im anregenden Laserstrahl detektierte Anteil bei der Frequenz $f_2$ auf Null geregelt wird Diese Art der Modulation ist in der DE 42 23 337 beschrieben. Der anregende Laserstrahl wird nach Passieren der Polarisationsweiche 19 und einer $\lambda$/4-Platte 20 mit der Optik 3 auf das Objekt 4 geführt. Der das Objekt 4 wieder verlassende Teil des Laserstrahles wird von der Optik 3 erfaßt, durchläuft die $\lambda$/4-Platte 20 erneut und wird an der Polarisationsweiche 19 auf den Laserdetektor 13 ausgekoppelt. Das Lumineszenzlicht wird von der Rückseite des Objektes 4 mittels des Lichtleiters 11 gesammelt und zum Lumineszenzdetektor 5 geleitet. Zur Abtrennung von störenden, durch das Objekt 4 transmittierten Anteilen des anregenden Laserlichtes kann wieder das Absorptionsfilter 9 in den Strahlengang eingefügt werden. Vom Lumineszenzdetektor 5 und vom Laserdetektor 13 gelangen die Signale zu den Lock-In-Verstärkern 6 und 14, die auf die Grundtaktfrequenz $f_2$ abgestimmt sind und ihr Referenzsignal aus der Modulatorbaugruppe 15 beziehen. Die weitere Signalverarbeitung erfolgt mit dem Signalprozessor 7 entsprechend der Beschreibung zu Fig.3.

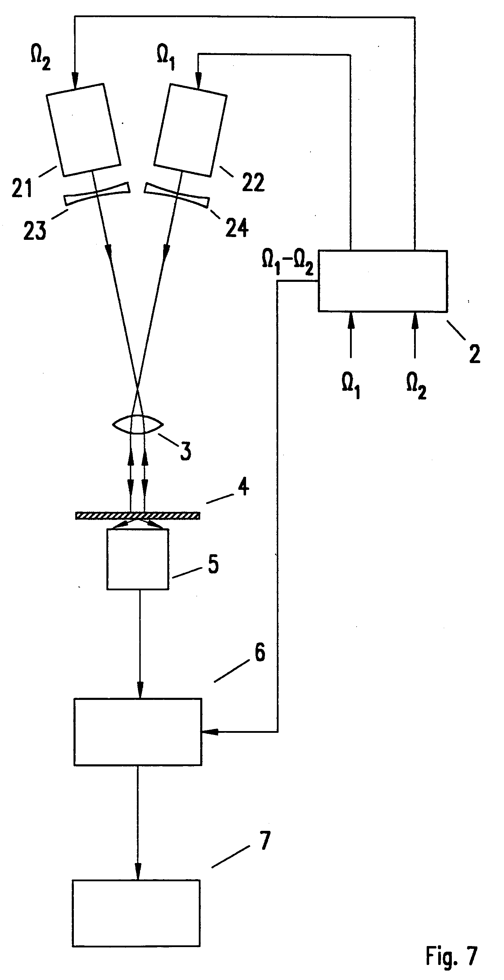

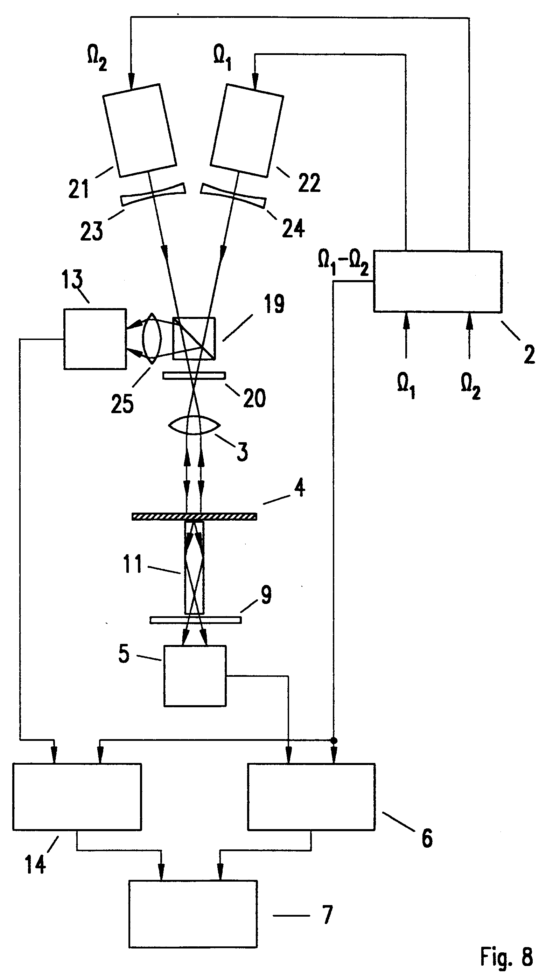

In allen bisher gezeigten Varianten wurden das Lumineszenzlicht und der Laserstrahl nach Wechselwirkung mit dem Objekt 4 auf der Differenzfrequenz $(\Omega_1-\Omega_2)$ entsprechend Anspruch 1 analysiert. Diese Ausführungsform ist besonders vorteilhaft, weil sich mittels einer gleichsinnigen Durchstimmung der beiden Modulationsfrequenzen $\Omega_1$ und $\Omega_2$ bei konstant gehaltenem Frequenzabstand in einfacher Weise eine Analyse über einen weiten Frequenzbereich durchführen läßt. Es kann aber mitunter nachteilig sein, daß aus dem detektierten Lumineszenzlicht keine Phaseninformation der Response gewonnen werden kann. Zur Gewinnung der Phaseninformation ist die Analyse bei der Summenfrequenz $(\Omega_1+\Omega_2)$ zweckmäßig. Diese Betriebsart ist besonders in Bezug auf die nachfolgend in Fig. 7 und Fig. 8 dargestellten Anordnungen vorteilhaft, ohne daß sie sich im Rahmen der Erfindung auf diese speziellen Anordnungen beschränkt.

In der Anordnung gemäß Fig.7 werden zwei Laserstrahlen durch zwei Laserdioden 21 und 22 erzeugt, deren Intensitäten mittels der Modulatorbaugruppe 2 mit je einer der Modulationsfrequenzen $\Omega_1$ und $\Omega_2$ moduliert werden. Beide Laserstrahlen treten in die Optik 3 ein und werden als räumlich getrennte, anregende Teilstrahlen auf das Objekt 4 fokussiert. Der Abstand der Auftreffpunkte kann durch Veränderung des Neigungswinkels der Teilstrahlen mittels zweier Schiebelinsen 23 und 24 variiert werden. Das aus der Rückseite des Objektes 4 austretende Lumineszenzlicht wird vom Lumineszenzdetektor 5 erfaßt. Vom Lumineszenzdetektor 5 gelangt das Meßsignal zum Lock-In-Verstärker 6, der auf die Differenzfrequenz $(\Omega_1-\Omega_2)$ abgestimmt ist und sein Referenzsignal aus der Modulatorbaugruppe 2 bezieht. Die weitere Signalverarbeitung erfolgt mit dem Signalprozessor 7, der das Ausgangssignal des Lock-In-Verstärkers 6 erfaßt und dieses Signal in Abhängigkeit von $\Omega_1$ und $\Omega_2$ und zusätzlich vom räumlichen Abstand der Auftreffpunkte der Teilstrahlen aufzeichnet und bewertet.

Die dem Wesen der Erfindung ebenfalls zuzurechnende Art der frequenzselektiven Meßwertaufnahme auf der Summenfrequenz $\Omega_1+\Omega_2$ der Modulationsfrequenzen $\Omega_1$ und $\Omega_2$ läßt sich in dieser Ausführungsvariante (wie auch in der Anordnung gemäß nachfolgender Fig. 8) vorteilhaft durchführen, indem das Lumineszenzlicht bei festen Modulationsfrequenzen $\Omega_1$ und $\Omega_2$ in Abhängigkeit vom gegenseitigen Abstand der Auftreffpunkte der anregenden Teilstrahlen analysiert wird.

In der Anordnung gemäß Fig. 8 werden zwei Laserstrahlen durch zwei Laserdioden 21 und 22 erzeugt, deren Intensitäten mit je einer der Frequenzen $(\Omega_1$ und $\Omega_2)$ moduliert werden. Die Signale für die Intensitätsmodulation werden von der Modulatorbaugruppe 2 bereitgestellt. Beide Laserstrahlen durchlaufen die Polarisationsweiche 19 und die $\lambda$/4-Platte 20, treten in die Optik 3 ein und werden als räumlich getrennte, anregende Teilstrahlen auf das Objekt 4 fokussiert. Der Abstand der Auftreffpunkte kann durch Veränderung des Neigungswinkels der Teilstrahlen mittels der beiden Schiebelinsen 23 und 24 variiert werden. Der das Objekt wieder verlassende Anteil der Anregungsstrahlen wird von der Optik 3 erfaßt, durchläuft die $\lambda$/4-Platte erneut, wird an der Polarisationsweiche 19 ausgekoppelt und mittels einer Linse 25 auf den Laserdetektor 13 geführt. Das aus der Rückseite des Objektes austretende Lumineszenzlicht wird vom Lichtleiter 11 erfaßt und auf den Lumineszenzdetektor 5 geführt. Für den Fall einer störenden Transmission von Anteilen des anregenden Laserlichtes durch das Objekt 4 hindurch kann wiederum das Absorptionfilter 9 in den Strahlengang eingefügt werden. Vom Lumineszenzdetektor 5 gelangt das Meßsignal zum Lock-In-Verstärker 6, der auf die Differenzfrequenz $(\Omega_1-\Omega_2)$ abgestimmt ist und sein Referenzsignal aus der Modulatorbaugruppe 2 bezieht. Die weitere Signalverarbeitung erfolgt mit dem Signalprozessor 7, der das Ausgangssignal des Lock-In-Verstärkers 6 erfaßt und in Abhängigkeit von $\Omega_1$ und $\Omega_2$ sowie vom räumlichen Abstand der Auftreffpunkte der Teilstrahlen aufzeichnet, bewertet und darüberhinaus entsprechend dem in Fig.3 dargestellten Ausführungsbeispiel die korrelierte Analyse der von den Detektoren 5 und 13 gelieferten Signale ausführt.

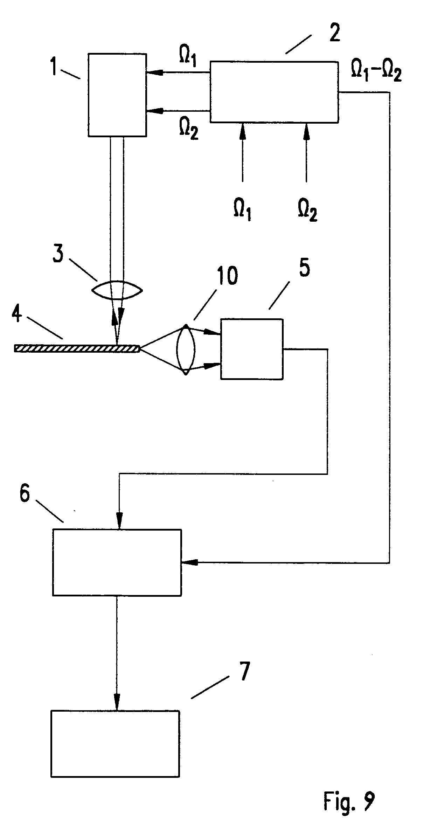

Fig. 9 zeigt eine Abwandlung der in Fig.1 gezeigten Grundanordnung. Diese modifizierte Anordnung ist anwendbar zur Untersuchung von Objekten, bei denen ein vergleichsweise hoher Anteil des Lumineszenzlichtes seitlich aus dem Objekt 4 austritt und dort leicht mittels eines Lumineszenzdetektors 5 aufnehmbar ist. Dies ist z.B. oft bei der Untersuchung von polierten Halbleiterscheiben der Fall, in denen sich ein vergleichsweise hoher Anteil des Lumineszenzlichtes durch Lichtleitung im Material ausbreiten kann. In der Anordnung gemäß Fig.9 wird der Laserstrahl von der Laserdiode 1 erzeugt, die mittels der Modulatorbaugruppe 2 in ihrer Intensität mit den beiden Frequenzen $\Omega_1$ und $\Omega_2$ moduliert wird. Der Laserstrahl wird mittels der Optik 3 fokussiert und auf das Objekt 4 geführt. Das seitlich aus dem Objekt 4 austretende Lumineszenzlicht wird mittels der Linse 10 gesammelt und dem Lumineszenzdetektor 5 zugeführt. Vom Lumineszenzdetektor 5 gelangt das Meßsignal zu einem Lock-In-Verstärker 6, der auf die Differenzfrequenz $(\Omega_1-\Omega_2)$ abgestimmt ist und sein Referenzsignal aus der Modulatorbaugruppe 2 bezieht. Die weitere Signalverarbeitung erfolgt mit einem Signalprozessor 7, der das Ausgangssignal des Lock-In-Verstärkers 6 erfaßt und dieses Signal in Abhängigkeit von $\Omega_1$ und $\Omega_2$ aufzeichnet und bewertet.

Die in dieser Fig. 9 gezeigte Detektion des seitlich aus dem Objekt 4 austretenden Lumineszenzlichtes ist selbstverständlich auch in allen anderen, in Anlehnung an Fig. 2 bis Fig. 8 beschriebenen Abwandlungen der erfindungsgemäßen Grundanordnung anwendbar.

Liste der verwendeten Bezugszeichen

| | |
|---|---|
| 1 | Laserquelle |
| 2 | Modulatorbaugruppe |
| 3 | Optik |
| 4 | Objekt |
| 5 | Lumineszenzdetektor |
| 6 | Lock-in-Verstärker |
| 7 | Signalprozessor |
| 8 | dichroitischer Spiegel |
| 9 | Absorptionsfilter |
| 10 | Optik |
| 11 | Lichtleiter |
| 13 | Laserdetektor |
| 14 | Lock-in-Verstärker |
| 15 | Modulatorbaugruppe |
| 16 | Strahlteiler |
| 17 | Referenzdetektor |
| 19 | Polarisationsweiche |
| 20 | $\lambda$/4-Platte |
| 21, 22 | Laserdiode |
| 23, 24 | Schiebelinsen |
| 25 | Linse |
| 26 | Polarisationsfilter |
| D | Diffusivität |
| $F_{cL}$ | Lumineszenz-Formfunktion |
| $l_c$ | Diffusionslänge |
| s | Oberflächenrekombinationsgeschwindigkeit |
| w | Laserspotradius |
| $\tau$ | Lebensdauer |
| $\Omega$ | arithmetisches Mittel derModulationsfrequenzen |
| $\Omega_1, \Omega_2$ | Modulationsfrequenzen |
| $(\Omega_1+\Omega_2)$ | Summenfrequenz |
| $(\Omega_1-\Omega_2)$ | Differenzfrequenz |

**Patentansprüche**

1. Verfahren zur Responseanalyse von optisch angeregten Halbleitermaterialien, wobei in einem Objekt mittels eines Laserstrahls eine elektronische Energiedeponierung in Form angeregter Ladungsträger erzeugt wird, deren Relaxation in Form einer aus dem Objekt austretenden Lumineszenz-Strahlung gemessen wird, dadurch gekennzeichnet, daß

- der anregende Laserstrahl intensitätsmoduliert ist, wobei das Frequenzspektrum zwei diskrete Modulationsfrequenzen ($\Omega_1$; $\Omega_2$) aufweist,
- das aus dem Objekt (4) austretende Lumineszenzlicht auf der Differenzfrequenz ($\Omega_1-\Omega_2$) der Modulationsfrequenzen ($\Omega_1$; $\Omega_2$) gemessen wird, und
- das Lumineszenzlicht als Funktion des arithmetischen Mittels der Modulationsfrequenzen ($\Omega_1$; $\Omega_2$) analysiert wird.

2. Verfahren nach Anspruch 1, dadurch gekennzeichnet, daß die zwei Modulationsfrequenzen ($\Omega_1$; $\Omega_2$) im einfallenden Laserstrahl durch die Zusammensetzung des Laserstrahls aus zwei Teilstrahlen erzeugt werden, die jeweils mit einer Modulationsfrequenz ($\Omega_1$; $\Omega_2$) intensitätsmoduliert sind.

**3.**Verfahren nach Anspruch 2, dadurch gekennzeichnet,
daß die Modulationsfrequenzen ($\Omega_1$; $\Omega_2$) des anregenden Laserstrahls in weiten Grenzen variiert werden, wobei die Differenz der Modulationsfrequenzen ($\Omega_1$; $\Omega_2$) konstant gehalten wird.

**4.**Verfahren nach Anspruch 2, dadurch gekennzeichnet,
daß die zwei Teilstrahlen senkrecht zueinander polarisiert werden.

**5.**Verfahren nach Anspruch 2, dadurch gekennzeichnet,
daß die zwei Teilstrahlen auf räumlich getrennte, eng benachbarte Auftreffpunkte des Objekts (4) fokussiert werden.

**6.**Verfahren nach Anspruch 5, dadurch gekennzeichnet,
daß die Teilstrahlen in einem Abstand von höchstens der zweifachen zu erwartenden Diffusionslänge der angeregten Ladungsträger auf das Objekt (4) fokussiert werden.

**7.**Verfahren nach Anspruch 1, dadurch gekennzeichnet, daß die zwei Modulationsfrequenzen ($\Omega_1$; $\Omega_2$) im einfallenden Laserstrahl erzeugt werden, indem der Laserstrahl mit einer Trägerfrequenz ($f_1$) und einer Grundtaktfrequenz ($f_2$) amplitudenmoduliert wird, wobei die Trägerfrequenz ($f_1$) und die Grundtaktfrequenz ($f_2$) gemäß den Vorschriften

$$f_1 = (\Omega_1 + \Omega_2)/2$$

$$f_2 = \Omega_1 - \Omega_2$$

eingestellt werden, und eine Komponente der Grundtaktfrequenz ($f_2$),die zu einer aus der Trägerfrequenz ($f_1$) und den Seitenbändern ($f_1 \pm f_2$) resultierenden Mischfrequenz phasengleich ist, erfaßt und mittels Rückkopplung dieser Komponente als Störgröße auf den Modulationsprozeß vernichtet wird.

**8.**Verfahren nach Anspruch 7, dadurch gekennzeichnet,
daß die Modulationsfrequenzen ($\Omega_1$; $\Omega_2$) bei konstant gehaltener Differenz in weiten Grenzen variiert werden.

**9.**Verfahren zur Responseanalyse von Halbleitermaterialien mit optischer Anregung, wobei in einem Objekt mittels eines Laserstrahls eine elektronische Energiedeponierung erzeugt wird, deren Relaxation in Form einer aus dem Objekt austretenden Lumineszenz-Strahlung gemessen wird, dadurch gekennzeichnet, daß

- der anregende Laserstrahl intensitätsmoduliert ist, wobei das Frequenzspektrum zwei diskrete Modulationsfrequenzen ($\Omega_1$; $\Omega_2$) aufweist,
- das aus dem Objekt (4) austretende Lumineszenzlicht auf der Summenfrequenz ($\Omega_1 + \Omega_2$) der Modulationsfrequenzen ($\Omega_1$; $\Omega_2$) gemessen wird, und
- das Lumineszenzlicht als Funktion des arithmetischen Mittels der Modulationsfrequenzen ($\Omega_1$; $\Omega_2$) analysiert wird.

**10.**Verfahren nach Anspruch 9, dadurch gekennzeichnet,
daß bei festen Modulationsfrequenzen $\Omega_1$ und $\Omega_2$ und bei Verwendung zweier auf räumlich getrennte, eng benachbarte Auftreffpunkte des Objekts (4) fokussierter Teilstrahlen das Lumineszenzlicht in Abhängigkeit vom gegenseitigen Abstand der Auftreffpunkte der anregenden Teilstrahlen analysiert wird.

**11.**Verfahren nach Anspruch 1, dadurch gekennzeichnet,
daß die Lumineszenz-Response auf der Seite des Objekts (4) gemessen wird, die vom Laserstrahl angeregt wird.

**12.**Verfahren nach Anspruch 1, dadurch gekennzeichnet,
daß die Lumineszenz-Response an der auf die Anregung bezogenen Rückseite des Objekts (4) gemessen wird.

**13.**Verfahren nach Anspruch 1, dadurch gekennzeichnet,
daß die Lumineszenz-Response an einer zur Anregungsseite des Objekts (4) beliebigen lateralen Seitenfläche gemessen wird.

**14.**Verfahren nach Anspruch 1, dadurch gekennzeichnet,
daß zusätzlich zur Messung des Lumineszenzlichts eine photothermische Response aus dem Laserstrahl nach seiner Wechselwirkung mit dem Objekt (4) aufgenommen wird und eine Analyse und Korrelation der zwei Responseprozesse erfolgt, so daß die nichtstrahlende Response des Objekts (4) separiert werden kann.

15. Verfahren nach Anspruch 14, dadurch gekennzeichnet,
daß die zwei Meßprozesse auf unterschiedlichen Seiten des Objekts (4) stattfinden.

16. Anordnung zur Responseanalyse von optisch angeregten Halbleitermaterialien, bei der ein Laserstrahl zur Erzeugung einer elektronischen Energiedeponierung in Form angeregter Ladungsträger auf ein Objekt fokussiert ist und ein Lumineszenzdetektor zur Messung einer aus dem Objekt austretenden Lumineszenz-Strahlung vorgesehen ist, dadurch gekennzeichnet, daß

- der Laserstrahl intensitätsmoduliert ist und in seinem Modulationsspektrum zwei diskrete Modulationsfrequenzen ($\Omega_1$; $\Omega_2$) enthält,
- der Lumineszenzdetektor (5) mit einer frequenzselektiven Einrichtung (6) verknüpft ist, wobei aus der Lumineszenzstrahlung nur Anteile auf der Differenzfrequenz ($\Omega_1$-$\Omega_2$) der Modulationsfrequenzen ($\Omega_1$; $\Omega_2$) detektierbar sind, die aus einer im Objekt stattfindenden Frequenzumsetzung resultieren und
- dem Lumineszenzdetektor (5) eine Signalverarbeitungseinrichtung nachgeordnet ist, die die frequenzselektiv erfaßten Detektorsignale als Funktion des arithmetischen Mittels der Modulationsfrequenzen ($\Omega_1$; $\Omega_2$) analysiert.

17. Anordnung nach Anspruch 16, dadurch gekennzeichnet,
daß eine Laserquelle (1) zur Erzeugung des doppelt modulierten Laserstrahls vorhanden ist, wobei eine Modulatorbaugruppe (2) zur Modulation der Laserquelle (1) mit beiden Modulationsfrequenzen ($\Omega_1$; $\Omega_2$) vorhanden ist.

18. Anordnung nach Anspruch 16, dadurch gekennzeichnet,
daß der Laserstrahl aus zwei Teilstrahlen zusammengesetzt ist, wobei jeder Teilstrahl mit einer der Modulationsfrequenzen ($\Omega_1$; $\Omega_2$) moduliert ist und die Modulation von einer Modulatorbaugruppe (2) gesteuert wird.

19. Anordnung nach Anspruch 18, dadurch gekennzeichnet,
daß eine Laserquelle (1) vorhanden ist, der ein optischer Teiler zur Erzeugung zweier Teilstrahlen folgt, wobei in jedem Teilstrahl ein optischer Modulator zur Modulation mit einer der Modulationsfrequenzen ($\Omega_1$; $\Omega_2$) angeordnet ist und den Modulatoren optische Mittel zur Vereinigung der Teilstrahlen nachgeordnet sind.

20. Anordnung nach Anspruch 19, dadurch gekennzeichnet,
daß in den Teilstrahlen optische Mittel zur Polarisation der Teilstrahlen vorhanden sind, so daß die Teilstrahlen senkrecht zueinander polarisiert sind.

21. Anordnung nach Anspruch 18, dadurch gekennzeichnet,
daß zwei separate Laserquellen (21;22) vorhanden sind, die mit einer Modulatorbaugruppe (2) in Verbindung stehen, wobei jede Laserquelle (21;22) mit einer der Modulationsfrequenzen ($\Omega_1$; $\Omega_2$) angesteuert wird.

22. Anordnung nach Anspruch 21, dadurch gekennzeichnet,
daß als Laserquellen (21;22) zwei Laserdioden so justiert sind, daß deren polarisiertes Licht senkrecht zueinander polarisierte Teilstrahlen bildet.

23. Anordnung nach Anspruch 22, dadurch gekennzeichnet,
daß die Teilstrahlen parallel zueinander in eine gemeinsame Optik geführt und auf einen Punkt der Objektoberfläche fokussiert sind.

24. Anordnung nach Anspruch 22, dadurch gekennzeichnet,
daß die Teilstrahlen koinzident zusammengefügt sind.

25. Anordnung nach Anspruch 22, dadurch gekennzeichnet,
daß die Teilstrahlen nicht parallel in eine gemeinsame Optik geführt sind, so daß eng benachbarte, räumlich getrennte Auftreffpunkte der Teilstrahlen auf dem Objekt (4) vorhanden sind.

26. Anordnung nach Anspruch 25, dadurch gekennzeichnet,
daß die Auftreffpunkte einen Abstand von höchstens der zweifachen zu erwartenden Diffusionslänge der angeregten Ladungsträger aufweisen.

27. Anordnung nach Anspruch 25, dadurch gekennzeichnet,
daß die frequenzselektive Einrichtung (6) so einstellbar ist, daß wahlweise zur Detektion auf der Differenzfrequenz ($\Omega_1$-$\Omega_2$) aus der Lumineszenzstrahlung nur Anteile auf der Summenfrequenz ($\Omega_1$+$\Omega_2$) der Modulationsfrequenzen ($\Omega_1$; $\Omega_2$) detektierbar sind, die aus einer im Objekt (4) stattfindenden Frequenzumsetzung resultieren.

28. Anordnung nach Anspruch 16, dadurch gekennzeichnet, daß
eine Ansteuereinrichtung zur Verschiebung der Modulationsfrequenzen ($\Omega_1$; $\Omega_2$) in weiten Grenzen vorgesehen ist, wobei die Ansteuereirrichtung mit der Modulatorbaugruppe (2) in Verbindung steht und die Differenz der Modulationsfrequenzen ($\Omega_1$; $\Omega_2$) stets konstant ist.

30. Anordnung nach Anspruch 16, dadurch gekennzeichnet,
daß ein Laserdetektor (13) zur Erfassung des Laserstrahls nach seiner Wechselwirkung mit dem Objekt (4) zusätzlich zum Lumineszenzdetektor (5) vorhanden ist.

31. Anordnung nach Anspruch 30, dadurch gekennzeichnet
daß die Ausgänge des Lumineszenzdetektors (5) und des Laserdetektors (13) aufjeweils einen Lock-in-Verstärker (6; 14) geführt sind, wobei beide Lock-in-Verstärker (6; 14) als frequenzselektive Einrichtungen auf die Differenzfrequenz ($\Omega_1$-$\Omega_2$) der Modulationsfrequenzen ($\Omega_1$; $\Omega_2$) abgestimmt und zur Zuführung von Referenzsignalen mit der Modulatorbaugruppe (2) verbunden sind, und die Signalverarbeitungseinrichtung ein Signalprozessor (7) zur Aufzeichnung, Bewertung und Korrelation der Ausgangssignale beider Lock-in-Verstärker (6; 14) ist und getrennte Informationen über strahlende und nichtstrahlende Relaxationsprozesse im Objekt (4) liefert.

32. Anordnung nach Anspruch 16, dadurch gekennzeichnet,
daß ein dichroitischer Spiegel (8) zur Abtrennung des Laserlichts von der Lumineszenzstrahlung vorgesehen ist.

33. Anordnung nach Anspruch 16, dadurch gekennzeichnet,
daß ein Absorptionsfilter (9) zur Abtrennung des störenden Laserlichts von der Lumineszenzstrahlung vor dem Lumineszenzdetektor (5) angeordnet ist.

Fig. 1

Fig. 2

Fig. 3

Fig. 4

$f_1, f_1 \pm f_2$  $f_2$

Fig. 5

Fig. 6

18

Fig. 7

Fig. 8

Fig. 9

**Fig. 10**

Fig. 11